Europäisches Patentamt

European Patent Office

Office européen des brevets

(19)

(11) EP 0 674 769 B1

(12) **EUROPÄISCHE PATENTSCHRIFT**

(45) Veröffentlichungstag und Bekanntmachung des Hinweises auf die Patenterteilung:
**08.05.1996 Patentblatt 1996/19**

(21) Anmeldenummer: **94901765.1**

(22) Anmeldetag: **16.12.1993**

(51) Int Cl.$^6$: **G01R 33/06**

(86) Internationale Anmeldenummer:
**PCT/DE93/01204**

(87) Internationale Veröffentlichungsnummer:
**WO 94/15223 (07.07.1994 Gazette 1994/15)**

(54) **MAGNETOWIDERSTANDS-SENSOR MIT KÜNSTLICHEM ANTIFERROMAGNETEN UND VERFAHREN ZU SEINER HERSTELLUNG**

MAGNETO-RESISTIVE SENSOR WITH A SYNTHETIC ANTI-FERROMAGNET, AND A METHOD OF PRODUCING THE SENSOR

DETECTEUR MAGNETO-RESISTIF MUNI D'UNE SUBSTANCE ANTIFERROMAGNETIQUE ET SON PROCEDE DE FABRICATION

(84) Benannte Vertragsstaaten:
**AT BE CH DE ES FR GB IT LI NL SE**

(30) Priorität: **21.12.1992 DE 4243358**

(43) Veröffentlichungstag der Anmeldung:
**04.10.1995 Patentblatt 1995/40**

(73) Patentinhaber: **SIEMENS AKTIENGESELLSCHAFT**
**D-80333 München (DE)**

(72) Erfinder: **VAN DEN BERG, Hugo**
**D-91074 Herzogenaurach (DE)**

(56) Entgegenhaltungen:
**EP-A- 0 346 817        EP-A- 0 432 890**
**EP-A- 0 498 668**

- **PHYSICAL REVIEW, B. CONDENSED MATTER, Bd.44, Nr.10, September 1991, NEW YORK US Seiten 5358 - 5361 SPERIOSU ET AL. 'Nonoscillatory magnetoresistance in Co/Cu/Co layered structures with oscillatory coupling'**

**Beschreibung**

Die Erfindung betrifft einen Magnetowiderstands-Sensor und ein Verfahren zu seiner Herstellung.

In ferromagnetischen Übergangsmetallen wie Nickel (Ni), Eisen (Fe) oder Kobalt (Co) und in Legierungen mit diesen Metallen ist der elektrische Widerstand abhängig von der Größe und Richtung eines das Material durchdringenden Magnetfeldes. Diesen Effekt nennt man anisotropen Magnetowiderstand (AMR) oder anisotropen magnetoresistiven Effekt. Er beruht physikalisch auf den unterschiedlichen Streuquerschnitten von Elektronen mit unterschiedlichem Spin, die entsprechend als Majoritäts- und Minoritätselektronen des D-Bandes bezeichnet werden. Für magnetoresistive Sensoren wird im allgemeinen eine dünne Schicht aus einem solchen magnetoresistiven Material mit einer Magnetisierung in der Schichtebene verwendet. Die Widerstandsänderung bei Drehung der Magnetisierung bezüglich der Stromrichtung kann einige Prozent des normalen isotropen Widerstandes betragen.

Es sind Mehrschichtsysteme bekannt mit mehreren, zu einem Stapel angeordneten ferromagnetischen Schichten, die durch metallische Zwischenschichten voneinander getrennt sind, und deren Magnetisierungen jeweils in der Schichtebene liegen. Die jeweiligen Schichtdicken sind dabei wesentlich kleiner als die mittlere freie Weglänge der Leitungselektronen gewählt. In solchen Schichtsystemen tritt nun zusätzlich zu dem anisotropen magnetoresistiven Effekt in den einzelnen Schichten der sogenannte Giant-magnetoresistive Effekt oder Giant-Magnetowiderstand (Giant-MR) auf, der auf der unterschiedlich starken Streuung von Majoritäts- und Minoritäts-Leitungselektronen im Volumen der Schichten, insbesondere in Legierungen, sowie an den Grenzflächen zwischen den ferromagnetischen Schichten und den Zwischenschichten beruht. Dieser Giant-MR ist ein isotroper Effekt und kann erheblich größer sein als der anisotrope MR mit Werten von bis zu 70 % des normalen isotropen Widerstandes.

Es sind zwei Grundtypen von solchen Giant-MR-Mehrschichtsystemen bekannt. Bei dem ersten Typ sind die ferromagnetischen Schichten über die Zwischenschichten antiferromagnetisch aneinander gekoppelt, so daß sich die in den Schichtebenen liegenden Magnetisierungen von zwei benachbarten ferromagnetischen Schichten ohne äußeres Magnetfeld antiparallel zueinander ausrichten. Ein Beispiel für diesen Typ sind Eisen-Chrom-Übergitter (Fe-Cr-Superlattices) mit ferromagnetischen Schichten aus Fe und antiferromagnetischen Zwischenschichten aus Cr. Durch ein äußeres Magnetfeld werden nun die Magnetisierungen von benachbarten ferromagnetischen Schichten gegen die antiferromagnetischen Kopplungskräfte gedreht und parallel ausgerichtet. Diese Umorientierung der Magnetisierungen durch das Magnetfeld hat eine stetige Abnahme des Giant-MR zur Folge, die ein Maß für die Größe des Magnetfeldes ist. Bei einer Sättigungsfeldstärke $H_S$

tritt keine Änderung des Giant-MR mehr auf, weil sämtliche Magnetisierungen dann parallel zueinander ausgerichtet sind. Der Giant-MR hängt dabei lediglich von dem Betrag der Feldstärke ab ("Physical Review Letters", Vol. 61, No. 21, 21. Nov. 1988, Seiten 2472 - 2475).

Für diesen Typ mit antiferromagnetisch gekoppelten, ferromagnetischen Schichten wurden auch theoretische Berechnungen durchgeführt, die eine Abhängigkeit der Strom- und der Transmissionskoeffizienten für an den Grenzflächen gestreute Elektronen mit Spin-up und solche mit Spin-down von dem Winkel zwischen den Magnetisierungen in benachbarten ferromagnetischen Schichten aufzeigen. Aus diesen Berechnungen ergibt sich, daß der Giant-MR bei von 0° auf 180° wachsendem Winkel zwischen den beiden Magnetisierungen stetig zunimmt und am größten bei einem Winkel von 180° ist ("Physical Review Letters", Vol. 63, No. 6, August 1989, Seiten 664 bis 667).

Bei dem zweiten Typ eines Giant-MR-Mehrschichtsystems sind ferromagnetische Schichten mit zueinander im Mittel parallelen Magnetisierungen in den Schichtebenen durch dia- oder paramagnetische Zwischenschichten aus Metall voneinander getrennt. Die Zwischenschichten sind so dick gewählt, daß die magnetische Austauschkopplung zwischen den Magnetisierungen der ferromagnetischen Schichten möglichst gering ist. Jeweils benachbarte ferromagnetische Schichten weisen unterschiedliche Koerzitivfeldstärken auf. Dadurch werden die in der Sättigung zunächst parallelen Mittelwerte der Magnetisierungen $M_1$ und $M_2$ von magnetisch weicheren Meßschichten und benachbarten, magnetisch härteren Biasschichten durch ein Magnetfeld H unterschiedlich stark gedreht, und es stellt sich ein vom Magnetfeld H abhängiger Winkel Phi zwischen den Mittelwerten der Magnetisierungen $M_1$ und $M_2$ ein. Die Abhängigkeit der einzelnen Magnetisierungen $M_1$ und $M_2$ vom Magnetfeld H ergibt sich dabei aus den entsprechenden Hysteresekurven des magnetisch weicheren bzw. des magnetisch härteren Materials. Zwischen den Koerzitivfeldstärken $H_{c1}$ der weichmagnetischen und $H_{c2}$ der hartmagnetischen Schichten und zwischen $-H_{c2}$ und $-H_{c1}$ liegt jeweils ein Bereich, in dem die Magnetisierung $M_1$ schon in Sättigung ist und die Magnetisierung $M_2$ noch ihren der Sättigung entsprechenden Wert hat und antiparallel zur Magnetisierung $M_1$ gerichtet ist, d.h. Phi = 180°. In diesem Bereich ist das MR-Signal maximal und konstant. Verschiedene Koerzitivfeldstärken $|H_{c1}| \leq |H_{c2}|$ kann man durch die Wahl unterschiedlicher Materialien oder durch unterschiedliche Herstellungsprozesse bzw. die Wahl unterschiedlicher Dicken des gleichen Materials einstellen. Bekannte Schichtstrukturen mit unterschiedlichen Materialien sind beispielsweise NiFe-Cu-Co-Schichtstrukturen und Fe-Cu-Co-Strukturen. Ein auf unterschiedlicher Herstellung oder unterschiedlichen Dicken beruhendes, bekanntes Schichtsystem ist ein Co-Au-Co-System ("Journal of Applied Physics", Vol. 70, No. 10, 15.

Nov. 1991, Seiten 5864 -5866). Das MR-Signal dieser bekannten Schichtsysteme hängt nun jedoch von ihrer Vorgeschichte ab, d.h. auf welchem Weg und zwischen welchen Werten für das Magnetfeld sowie in welcher Richtung die Hysteresekurven durchlaufen werden. Mit einem solchen Schichtsystem läßt sich daher kein MR-Sensor mit einer eindeutigen Kennlinie realisieren. Außerdem schließt sich bei diesen bekannten Schichtsystemen ein Teil des Magnetflusses der härteren Biasschichten über den weicheren Meßschichten. Dieses magnetische Störfeld verringert die Meßempfindlichkeit des Sensors und hat eine unerwünschte Verschiebung der Sensorkennlinie zur Folge.

Aus der EP-A-0 346 817 ist ein Magnetowiderstands-Sensor bekannt mit einem Schichtsystem aus einer ferromagnetischen Meßschicht und einer ferromagnetischen Biasschicht, die durch eine nichtmagnetische Zwischenschicht voneinander austauschentkoppelt sind, und mit Meßkontakten an dem Schichtsystem zum Anlegen eines elektrischen Stromes und Abgreifen einer Meßspannung, die ein Maß für ein anliegendes Magnetfeld ist. In einer ersten Ausführungsform dieses bekannten Magnetowiderstands-Sensors weist die Meßschicht eine kleinere Koerzitivfeldstärke auf als die Biasschicht. In einer zweiten Ausführungsform liegt dagegen an der Biasschicht eine antiferromagnetische Schicht an. Die Meßschicht weist somit eine im Meßbereich des Magnetfeldes reversibel vom Magnetfeld abhängende, drehbare Magnetisierung in der Schichtebene auf, während die Biasschicht eine in diesem Meßbereich konstante Magnetisierung in ihrer Schichtebene aufweist.

Der Erfindung liegt deshalb die Aufgabe zugrunde, einen Magnetowiderstands-Sensor mit einem Schichtsystem aus wenigstens einer Meßschicht und wenigstens einer durch eine Zwischenschicht von der Meßschicht austauschentkoppelten Biasschicht anzugeben, der eine eindeutige Kennlinie aufweist und bei dem Störfelder der Biasschicht in der Meßschicht weitgehend unterdrückt werden. Insbesondere soll ein linearer Magnetowiderstands-Sensor angegeben werden. Außerdem ist ein Verfahren zur Herstellung eines solchen Magnetowiderstands-Sensors anzugeben.

Diese Aufgabe wird gemäß der Erfindung gelöst mit den Merkmalen des Anspruchs 1 bzw. des Anspruchs 20. Die Magnetisierung $\overline{M}_M$ der Meßschicht hängt wenigstens in einer Richtung reversibel und damit eindeutig vom zu messenden Magnetfeld ab und die Biasschicht ist mit einer im Meßbereich wenigstens annähernd konstanten Magnetisierung $\overline{M}_B$ versehen. Dadurch erhält man ein Widerstandssignal, das eindeutig von dem Magnetfeld abhängt. Um zu verhindern, daß sich ein Teil des Magnetflusses der Biasschicht, insbesondere bei großem $\overline{M}_B$, über der Meßschicht schließt, ist nun die Biasschicht an ihrer von der Meßschicht abgewandten Seite antiferromagnetisch über eine Kopplungsschicht an eine Magnetschicht angekoppelt. Die Biasschicht, die Kopplungschicht und die Magnetschicht bilden einen "künstlichen Antiferromagneten", der nach außen magnetisch weitgehend neutral ist, d. h. dessen Magnetfluß sich praktisch ganz zwischen der Biasschicht und der Magnetschicht schließt. Ein besonderer Vorteil dieses "künstlichen Antiferromagneten" ist die Stabilisierung der Magnetisierung $\overline{M}_B$ der Biasschicht auch bei starken äußeren Magnetfeldern H. Zur Messung des Widerstands des Schichtsystems sind wenigstens zwei Meßkontakte vorgesehen.

Diese Meßkontakte können in einem Abstand voneinander vorzugsweise auf der obersten Schicht angeordnet sein, so daß der Meßstrom im Mittel parallel zu den Schichtebenen fließt (cip = current-in-planes). In einer anderen Ausführungsform sind die Meßkontakte auf der obersten und der untersten Schicht angeordnet, so daß der Meßstrom senkrecht zu den Schichtebenen fließt (cpp = current-perpendicular-to-planes). Ein Schichtsystem mit derartig angeordneten cpp-Meßkontakten ist aus "Physical Review B", Vol. 46, No. 1 (1992), Seiten 548 - 551 bekannt.

In einem vorteilhaften, symmetrischen Aufbau ist auf der anderen Seite der Magnetschicht eine weitere Biasschicht angeordnet, die über eine Kopplungsschicht mit der Magnetschicht antiferromagnetisch gekoppelt ist.

Vorzugsweise ist die Meßschicht mit einer magnetischen Vorzugsachse $A_M$ versehen. Die Meßschicht kann allerdings auch aus einem superparamagnetischen Material gewählt sein. Dann ist ihre Magnetisierung $\overline{M}_M$ in allen Richtungen reversibel vom Magnetfeld abhängig.

Im Grundzustand, d.h. wenn kein Magnetfeld anliegt, stellt sich eine Grundzustandsmagnetisierung $\overline{M}_{MO}$ der Meßschicht ein. Diese Grundzustandsmagnetisierung $\overline{M}_{MO}$ der Meßschicht ist nun in einer Ausführungsform parallel zur Magnetisierung oder den Magnetisierungen $\overline{M}_B$ der Biasschicht bzw. der Biasschichten parallel gerichtet. Dazu wird die Meßschicht entlang einer parallel zur Magnetisierung $\overline{M}_B$ gerichteten Vorzugsachse magnetisiert.

In einer besonders vorteilhaften Ausführungsform sind die Grundzustandsmagnetisierung $\overline{M}_{MO}$ der Meßschicht und die feste Magnetisierung $\overline{M}_B$ der Biasschicht wenigstens annähernd senkrecht zueinander gerichtet. Dadurch wird der Arbeitspunkt des Sensors bei nicht vorhandenem Magnetfeld H = 0 in einem Bereich eingestellt, in dem die Kennlinie wenigstens annähernd linear ist und eine maximale Steigung aufweist.

Um die Magnetisierungen $\overline{M}_{MO}$ und $\overline{M}_B$ wenigstens annähernd senkrecht zueinander auszurichten, wird die Meßschicht vorzugsweise mit einer magnetischen Vorzugsachse $A_M$ versehen, die wenigstens annähernd senkrecht zur festen Magnetisierung $\overline{M}_B$ der Biasschicht gerichtet ist, und entlang dieser Vorzugsachse $A_M$ magnetisiert.

In einer anderen Ausführungsform wird die sogenannte 90°-Kopplung ausgenutzt. Die Dicke der Zwischenschicht wird auf einen Wert eingestellt, bei dem die magnetische Austauschkopplung zwischen Meßschicht und Biasschicht ihr Vorzeichen wechselt, d. h. von einer ferromagnetischen in eine antiferromagnetische Kopplung übergeht bzw. umgekehrt. Durch die statistischen Schwankungen der Dicke stellt sich nun die Grundzustandsmagnetisierung $\overline{M}_{MO}$ der Meßschicht im Mittel automatisch unter einem Winkel von 90° zur Magnetisierung $\overline{M}_B$ der Biasschicht ein.

Bei verschiedenen Materialien und verschiedener Geometrie der Schichten kann es zur Kompensation der entstehenden entmagnetisierenden Felder erforderlich sein, einen etwas von 90° abweichenden Winkel zwischen $\overline{M}_{MO}$ und $\overline{M}_B$ einzustellen, um den für Linearität und Empfindlichkeit des Sensors optimalen Arbeitspunkt zu erreichen.

Stärkere Abweichungen von der wenigstens annähernd senkrechten Ausrichtung der Magnetisierungen $\overline{M}_{MO}$ und $\overline{M}_B$ zueinander verschlechtern die Empfindlichkeit und die Linearität des Sensors.

Eine Ursache für solche störende Abweichungen des Winkels zwischen den beiden Magnetisierungen $\overline{M}_{MO}$ und $\overline{M}_B$ von den gewünschten etwa 90° kann sein, wenn sich immer noch ein Rest des magnetischen Flusses der Biasschicht über der Meßschicht schließt. Die Grundzustandsmagnetisierung $\overline{M}_{MO}$ in der Meßschicht wird dann im ungünstigsten Fall dieser magnetostatischen Kopplung von Meßschicht und Biasschicht schon antiparallel zur Magnetisierung $\overline{M}_B$ in der Biasschicht ausgerichtet, ohne daß ein Magnetfeld anliegt.

In einer besonderen Ausführungsform ist die Meßschicht zur zusätzlichen magnetostatischen Entkopplung von der Biasschicht wenigstens in Richtung der Magnetisierung $\overline{M}_B$ der Biasschicht und vorzugsweise ringsum außen kürzer ausgebildet als wenigstens die Biasschicht. Vorzugsweise werden die Übergänge zwischen den Randbereichen ohne Meßschicht und dem mittleren Meßbereich mit der Meßschicht fließend gestaltet. Beispielsweise kann die Dicke der Meßschicht in diesen Übergangsbereichen zur Mitte hin kontinuierlich zunehmen.

In einer weiteren Ausführungsform ist zur weiteren magnetostatischen Entkopplung die Magnetisierung l$\overline{M}_B$l der Biasschicht niedriger gewählt als die Grundzustandsmagnetisierung l$\overline{M}_{MO}$l der Meßschicht.

Auch aufgrund von entmagnetisierenden Feldern vor allem in den Randbereichen der Schichten und insbesondere in der Biasschicht können Abweichungen von den vorgegebenen Richtungen für die Magnetisierungen $\overline{M}_{MO}$ und $\overline{M}_B$ auftreten. Deshalb sind in einer bevorzugten Ausführungsform die Meßkontakte zur Widerstandsmessung in einen inneren Meßbereich des Schichtsystems verlegt, um den Einfluß dieser Randbereiche auf das Meßsignal zu vermeiden.

In einer besonders vorteilhaften Ausführungsform sind die Schichten länglich ausgebildet, wobei ihre Längsrichtung senkrecht zur Grundzustandsmagnetisierung $\overline{M}_{MO}$ der Meßschicht verläuft. Dadurch ist die relative Lage der Grundzustandsmagnetisierung $\overline{M}_{MO}$

und der Magnetisierung $\overline{M}_B$ zueinander besonders stabil. Zudem erreicht man eine hohe Empfindlichkeit des Sensors und verringert die Verschiebung seiner Kennlinie, weil die von der Meßschicht bzw. der Biasschicht erzeugten entmagnetisierenden Felder stark abgeschwächt werden und ihr dem zu messenden Magnetfeld entgegenwirkender Einfluß verringert wird.

Zur Magnetflußumlenkung und für eine geringere Domänenbildung kann in einer weiteren Ausführungsform wenigstens eine Meßschicht durch zwei Meßschichten mit antiparallel zueinander gerichteten Magnetisierungen ersetzt werden, die durch eine Zwischenschicht getrennt sind. Vorzugsweise sind beide Magnetisierungen gegen die Normalenrichtung zur Magnetisierung $\overline{M}_B$ der Biasschicht so geneigt, daß sie einen Winkel kleiner als 180° einschließen. Dadurch wird die Bildung von Domänen in den Meßschichten verringert.

In einer besonders vorteilhaften Ausführungsform werden die Materialien für die Schichten des Sensors derart gewählt, daß der spezifische Widerstand für denjenigen Elektronentyp, der in der Meßschicht bei parallel zueinander gerichteten Magnetisierungen $\overline{M}_M$ und $\overline{M}_B$ in Meßschicht und Biasschicht nur wenig gestreut wird, auch in den anderen Schichten, insbesondere der Magnetschicht des künstlichen Antiferromagneten, und an ihren Grenzflächen möglichst gering ist. Bei einer solchen Wahl erreicht man einen sehr guten Kontrast zwischen dem maximalen und dem minimalen Magnetowiderstandssignal. Als entscheidende Parameter werden dabei die Verhältnisse von spezifischem Widerstand für die Minoritätsträger und spezifischen Widerstand für die Majoritätsträger in den einzelnen Schichten und an ihren Grenzflächen eingestellt. Diese Parameter werden durch die jeweiligen Wirtsmaterialien und Fremdatome als Streuzentren bestimmt. Die parallele Ausrichtung der Magnetisierungen $\overline{M}_M$ und $\overline{M}_B$ kann dabei schon im Grundzustand oder erst bei einem parallel zu $\overline{M}_B$ anliegenden Magnetfeld vorliegen.

Die bisher beschriebenen Ausführungsformen von Schichtsubsystemen können miteinander kombiniert werden und in einem Stapel aus einer Vielzahl solcher Subsysteme angeordnet werden. Die Zahl dieser Schichtsubsysteme wird im allgemeinen zwischen 1 und 100 gewählt. Das Basissubsystem ist das System Meßschicht-Zwischenschicht- "künstlicher Antiferromagnet", wobei der "künstliche Antiferromagnet" aus Biasschicht, Kopplungsschicht und Magnetschicht oder im symmetrischen Aufbau aus zwei Biasschichten mit einer dazwischen angeordneten und jeweils über eine Kopplungsschicht antiferromagnetisch an die Biasschichten gekoppelten Magnetschicht bestehen kann. Die Magnetisierungen $\overline{M}_B$ der Biasschichten sind in allen Ausführungsformen gleich gerichtet. Die Grundzustandsmagnetisierungen $\overline{M}_{MO}$ der Meßschichten sind entweder kollinear oder senkrecht zu den Magnetisierungen $\overline{M}_B$ der Biasschichten gerichtet. Die Subsysteme sind jeweils durch eine weitere Zwischenschicht voneinander getrennt.

Ein Magnetowiderstands-Sensor gemäß der Erfindung, insbesondere der "künstliche Antiferromagnet", kann auf mehreren Wegen hergestellt werden.

Eine Möglichkeit besteht darin, für die Biasschicht und die Magnetschicht des "künstlichen Antiferromagneten" Materialien mit unterschiedlichen Koerzitivfeldstärken zu wählen. Die beiden Schichten werden in einem uniformen Biasmagnetfeld, das größer ist als beide Koerzitivfeldstärken, gesättigt. Bei abnehmendem Magnetfeld richtet sich nun die Magnetisierung des magnetisch weicheren Materials wegen der antiferromagnetischen Austauschkoppelung antiparallel zur Magnetisierung des magnetisch härteren Materials aus.

Eine zweite Möglichkeit ist das Einprägen einer feldinduzierten Vorzugsachse in die Biasschicht durch ein Biasmagnetfeld während der Ablagerung der Schichten in einem Vakuumsystem und ein anschließendes Magnetisieren der Biasschicht entlang dieser Vorzugsachse. Die Magnetisierung der antiferromagnetisch gekoppelten Magnetschicht stellt sich dann von selbst antiparallel zur Magnetisierung $\overline{M}_B$ der Biasschicht ein. Es kann allerdings auch umgekehrt die Magnetschicht mit einer Vorzugsachse versehen werden und entlang dieser Vorzugsachse magnetisiert werden.

Eine dritte Möglichkeit der Herstellung des künstlichen Antiferromagneten bietet die Wahl zweier magnetischer Materialien mit unterschiedlicher Curietemperatur und wenigstens annähernd gleicher Magnetisierung bei Raumtemperatur bzw. allgemein der Einsatztemperatur des Sensors für die Biasschicht und die Magnetschicht. Die Biasschicht und die Magnetschicht werden zusammen mit der dazwischen angeordneten Kopplungsschicht auf eine Einprägetemperatur gebracht, bei der sich die Magnetisierbarkeiten der beiden Materialien unterscheiden, und in einem temperaturabhängigen Biasmagnetfeld gesättigt, das wenigstens bei der Einprägetemperatur einen von Null verschiedenen Wert zum Sättigen hat und beispielsweise kontinuierlich oder sprunghaft von der Temperatur abhängen kann. Liegt die Einprägetemperatur oberhalb der Einsatztemperatur, so wird die Schicht mit der höheren Curietemperatur stärker magnetisiert. Bei einer tiefer als die Einsatztemperatur liegenden Einprägetemperatur wird im allgemeinen die Schicht mit der niedrigeren Curietemperatur stärker magnetisiert. Bei einer darauffolgenden Temperaturänderung auf die Einsatztemperatur wird sich die Magnetisierung der stärker magnetisierten Schicht nicht mehr ändern und die Magnetisierung der anderen Schicht wird durch die antiferromagnetische Kopplung antiparallel ausgerichtet. Im allgemeinen wird die Einprägetemperatur höher gewählt als die Einsatztemperatur.

Die drei genannten Möglichkeiten der Wahl der Materialeigenschaften für den "künstlichen Antiferromagneten" können natürlich auch beliebig kombiniert werden.

Zur weiteren Erläuterung der Erfindung wird auf die Zeichnung Bezug genommen, in deren

| FIG. 1 und 2 | jeweils eine Ausführungsform eines Magnetowiderstands-Sensors gemäß der Erfindung im Querschnitt, |
| FIG. 3 | eine Ausführungsform mit nach innen verlegten Meßkontakten in der Draufsicht, |
| FIG. 4 | eine Ausführungsform mit Randbereichen ohne Meßschicht im Querschnitt und |
| FIG. 5 | eine Ausführungsform mit zwei benachbarten Meßschichten im Querschnitt |

schematisch dargestellt sind.

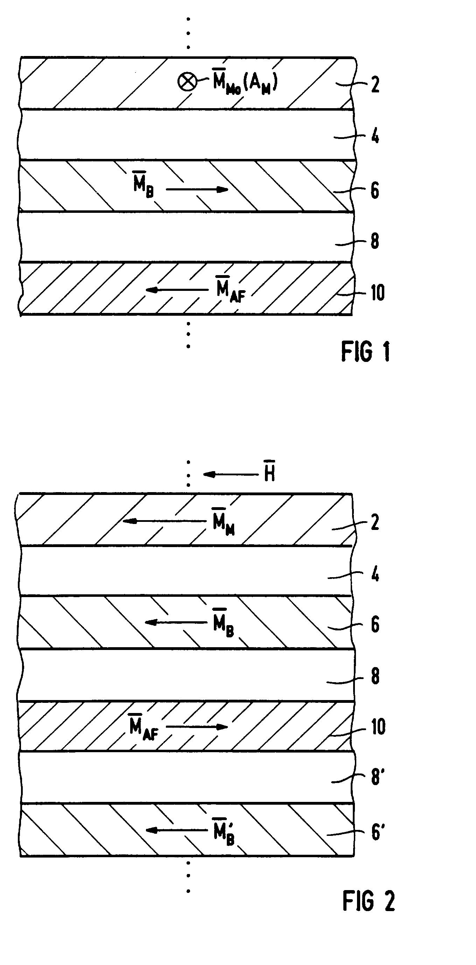

FIG. 1 zeigt eine Ausführungsform eines MagnetowiderstandSensors mit einem Schichtsubsystem, das aus einer magnetischen Meßschicht 2 und einer magnetischen Biasschicht 6, einer dazwischen angeordneten, nicht magnetischen Zwischenschicht 4, sowie einer an die von der Meßschicht 2 abgewandten Seite der Biasschicht 6 über eine Kopplungsschicht 8 antiferromagnetisch angekoppelte Magnetschicht 10 gebildet ist. Alle Schichten bestehen aus einem elektrisch leitendem Material, und ihre Dicken sind wesentlich kleiner als die mittlere freie Weglänge der Leitungselektronen. Die Meßschicht 2 weist eine Grundzustandsmagnetisierung $\overline{M}_{MO}$ entlang einer Vorzugsachse auf, die mit $A_M$ bezeichnet ist und in der Schichtebene der Meßschicht 2 verläuft. Die Biasschicht 6 ist mit einer festen Magnetisierung $\overline{M}_B$ in ihrer Schichtebene versehen, die wenigstens annähernd senkrecht zur Vorzugsachse $A_M$ der Meßschicht 2 gerichtet ist und in der Zeichenebene dargestellt ist. Die Magnetisierung $\overline{M}_B$ kann allerdings auch umgekehrt gerichtet sein. Durch die wenigstens annähernd orthogonale Ausrichtung der Vorzugsachse $A_M$ und damit der Grundzustandsmagnetisierung $\overline{M}_{MO}$ relativ zur Magnetisierung $\overline{M}_B$ liegt der Arbeitspunkt des Sensors in dieser bevorzugten Ausführungsform in einem wenigstens annähernd linearen Bereich der Kennlinie mit zugleich der größten Steigung. Der Winkel zwischen den beiden Magnetisierungen $\overline{M}_{MO}$ und $\overline{M}_B$ kann zur Kompensation von entmagnetisierenden Feldern etwas von 90° abweichen.

Wegen der antiferromagnetischen Kopplung ist die Magnetisierung $\overline{M}_{AF}$ der Magnetschicht 10 antiparallel zur Magnetisierung $\overline{M}_B$ der Biasschicht 6 gerichtet. Die Biasschicht 6, die Kopplungsschicht 8 und die Magnetschicht 10 bilden zusammen einen "künstlichen Antiferromagneten", der nach außen weitgehend magnetisch neutral ist, weil der Magnetfluß im wesentlichen nur zwischen der Biasschicht 6 und der Magnetschicht 10 verläuft. Die Richtung der Magnetisierung $\overline{M}_B$ der Biasschicht 6 ist dadurch auch bei hohen äußeren Feldern sehr stabil.

Wird nun ein in FIG. 1 nicht dargestelltes Magnetfeld $\overline{H}$ in der Schichtebene angelegt, dann ändert sich

die Magnetisierung $\overline{M}_M$ in der Meßschicht 2 aus der Grundzustandsmagnetisierung $\overline{M}_{MO}$ und die Magnetisierung $\overline{M}_B$ der Biasschicht 6 bleibt im wesentlichen unverändert. Eine Komponente $\overline{H}_V$ des Magnetfeldes H senkrecht zur Vorzugsachse $A_M$ der Meßschicht 2 dreht die Magnetisierung $\overline{M}_M$ der Meßschicht 2 in Richtung zur Magnetisierung $\overline{M}_B$ bzw. -$\overline{M}_B$, entsprechend der Feldrichtung $\overline{H}$ . In der Sättigung sind die beiden Magnetisierungen $\overline{M}_M$ und $\overline{M}_B$ dann parallel bzw. antiparallel gerichtet. Dieser Drehprozeß erzeugt ein Giant-Magnetowiderstandssignal in Abhängigkeit vom Drehwinkel. Eine Komponente $\overline{H}_p$ des Magnetfeldes $\overline{H}$ parallel zur Vorzugsachse $A_M$ dagegen bewirkt eine Domänenwandverschiebung und somit lediglich eine Richtungsumkehr der Magnetisierung $\overline{M}_M$ an den Domänenwänden. Ein Magnetowiderstandssignal wird dadurch nicht erzeugt. Bei einem Magnetfeld senkrecht zur Schichtebene finden wegen der hohen entmagnetisierenden Felder in der Meßschicht 2 ebenfalls praktisch keine Drehprozesse statt, und damit wird auch kein Magnetowiderstandssignal gemessen. Der Magnetowiderstands-Sensor ist also im wesentlichen nur empfindlich für die Komponente $\overline{H}_V$ des Magnetfeldes $\overline{H}$, die orthogonal zur Vorzugsachse $A_M$ in dieser Ausführungsform bzw. allgemein zur Grundzustandsmagnetisierung $\overline{M}_{MO}$ der Meßschicht 2 gerichtet ist.

Die Magnetisierung $\overline{M}_B$ der Biasschicht 6 soll in dem Meßbereich des anliegenden Feldes H konstant bleiben und insbesondere sich nicht in der Schichtebene drehen. Dazu kann in einer Ausführungsform in die wenigstens eine Biasschicht eine magnetische, uniaxiale Anisotropie, insbesondere eine Kristallanisotropie, eine feldinduzierte Anisotropie oder eine spannungsinduzierte Anisotropie, eingeprägt werden. Die Biasschicht wird dann entlang der Anisotropieachse magnetisiert.

In einer Ausführungsform gemäß FIG. 2 ist ein "künstlicher Antiferromagnet" mit einem symmetrischen Aufbau vorgesehen. Die Magnetschicht 10 ist auf einer Seite wieder über die Koppelungsschicht 8 an die Biasschicht 6 antiferromagnetisch angekoppelt. Auf der anderen Seite der Magnetschicht 10 sind nun eine weitere Kopplungsschicht 8' und darauf eine weitere Biasschicht 6' angeordnet. Die Biasschicht 6' und die Magnetschicht 10 sind ebenfalls antiferromagnetisch gekoppelt, sodaß die Magnetisierungen $\overline{M}_B$ und $\overline{M}_B$' der beiden Biasschichten 6 und 6' parallel zueinander und beide antiparallel zur Magnetisierung $\overline{M}_{AF}$ der Magnetschicht 10 gerichtet sind. Auf der Biasschicht 6 ist wieder die Zwischenschicht 4 und auf dieser die Meßschicht 2 angeordnet. Auch an die Biasschicht 6' können sich eine weitere Zwischenschicht und eine weitere Meßschicht anschließen. In der dargestellten Ausführungsform ist die Magnetisierung $\overline{M}_M$ der Meßschicht 2 parallel zu den Magnetisierungen $\overline{M}_B$ und $\overline{M}_B$' der Biasschichten 6 und 6' gerichtet. In diese Lage kann die Magnetisierung $\overline{M}_M$ aus der zu $\overline{M}_B$ orthogonalen Grundzustandsmagnetisierung $\overline{M}_{MO}$ durch ein Magnetfeld $\overline{H}$ gedreht worden sein oder auch in einer nicht dargestellten Ausführungsform schon im Grundzustand eingestellt sein, beispielsweise durch Einprägen einer entsprechenden Vorzugsachse.

Zur Widerstandsmessung sind, vorzugsweise auf der obersten Schicht des Schichtssystems, zwei Meßkontakte in einem Abstand zueinander angeordnet, der vorzugsweise wesentlich größer als die Dicke des Schichtsystems ist (cip). In einer anderen Ausführungsform sind die Meßkontakte auf der Oberseite und der Unterseite des Schichtsystems angeordnet (cpp). Ihr Abstand entspricht dann der Dicke des Schichtsystems. Typische Dicken des gesamten Schichtssystems liegen zwischen 3 nm und 400 nm und typische Abstände der Meßkontakte in einem Bereich von 3 nm bis 1 mm. Zwischen den beiden - in FIG. 2 nicht dargestellten - Meßkontakten bildet sich in dem gesamten Schichtssystem ein elektrischer Strom von Leitungselektronen aus. Dieser Strom läßt sich aus zwei nicht wechselwirkenden Teilströmen superponieren, die sich aus Elektronen unterschiedlicher Spins zusammensetzen. In den magnetisierten Schichten gibt es nun einen Teilstrom von Majoritätselektronen, deren Spins im Mittel parallel zur Magnetisierung der entsprechenden Schicht gerichtet sind, und einen Teilstrom von Minoritätsträgern mit im Mittel antiparallel zur Magnetisierung gerichteten Spins. In magnetischen Übergangsmetallen, die vorzugsweise als Materialien für diese Schichten vorgesehen sind, sind die Streuquerschnitte der aus Fremdatomen gebildeten Streuzentren für Elektronen mit unterschiedlichem Spin unterschiedlich groß. Solche Streuzentren befinden sich sowohl innerhalb der magnetischen Schichten als auch an ihren Grenzflächen. Die Streuung der Elektronen in den nicht-magnetischen Zwischenschichten und den Kopplungsschichten ist dagegen spinunabhängig. Somit weisen sowohl die magnetischen Schichten als auch die Grenzflächen zu diesen Schichten für Majoritätselektronen und Minoritätselektronen unterschiedliche spezifische Widerstände RHOMAJ bzw. RHOMIN auf. Das Verhältnis ALPHA = RHOMIN/RHOMAJ des Widerstandes RHOMIN für die Minoritätsträger zum Widerstand RHOMAJ für die Majoritätsträger ist abhängig vom Wirtsmaterial und den Defekten.

Um einen möglichst großen Unterschied zwischen minimalem und maximalem Giant-Magnetowiderstandssignal zu erhalten, werden nun die Materialien für die einzelnen Schichten so gewählt, daß die Elektronen mit dem geringeren Widerstand in der Meßschicht 2 bei parallel zueinander gerichteten Magnetisierungen $\overline{M}_M$ und $\overline{M}_B$ der Meßschicht 2 und der Biasschicht 6 auch in allen anderen magnetischen Schichten und an allen Grenzflächen zwischen den Schichten weniger gestreut werden. Das erreicht man, indem man die Parameter ALPHA für die Schichten mit zur Meßschicht 2 paralleler Magnetisierung und für ihre Grenzflächen alle größer oder alle kleiner als eins wählt. Das bedeutet in der dargestellten Ausführungsform, daß die Parameter ALPHA für die Meßschicht 2, ihre Grenzfläche zur Zwischenschicht 4, für die Biasschicht 6 und ihre beiden Grenzflächen zur Zwischenschicht 4 bzw. zur Kopplungsschicht 8 und für die weitere Biasschicht 6' und ihre Grenzfläche zur Kopplungsschicht 8' entweder alle größer oder alle kleiner als eins eingestellt werden.

In der Magnetschicht 10 ist nun die Magnetisierung $\overline{M}_{AF}$ antiparallel zu den Magnetisierungen $\overline{M}_M$, $\overline{M}_B$ und $\overline{M}_B'$ der anderen magnetisierten Schichten gerichtet. Elektronen, die in der Meßschicht 2 und den Biasschichten 6 und 6' Majoritätsträger sind, werden in der Magnetschicht 10 daher zu Minoritätsträgern und umgekehrt. Deshalb werden die Parameter ALPHA für die Magnetschicht 10 und ihre beiden Grenzflächen zu den Kopplungsschichten 8 und 8' größer als eins gewählt, wenn die ALPHAs der anderen magnetisierten Schichten und ihrer Grenzflächen kleiner als eins sind, und kleiner als eins, wenn die anderen ALPHAs größer eins sind. Vorzugsweise werden die ALPHAs der Meßschicht 2 und der Biasschichten 6 und 6' sowie ihrer Grenzflächen größer als eins und der Magnetschicht 10 und ihrer Grenzflächen kleiner eins gewählt. Dann trägt zum Strom zwischen den Meßkontakten hauptsächlich nur der Teilstrom der Majoritätsträger bei, wenn die Magnetisierung $\overline{M}_M$ parallel zu $\overline{M}_B$ ist.

Dreht nun ein äußeres Magnetfeld $\overline{H}$ die Magnetisierung $\overline{M}_M$ der Meßschicht 2 in eine zur Magnetisierung $\overline{M}_B$ der Biasschicht 6 antiparallele Lage, so werden die bisherigen Majoritätselektronen in der Meßschicht 2 zu Minoritätselektronen in den Biasschichten 6 und somit in dem gesamten Schichtsystem stark gestreut. Damit steigt das GiantWiderstandsignal auf seinen maximalen Wert.

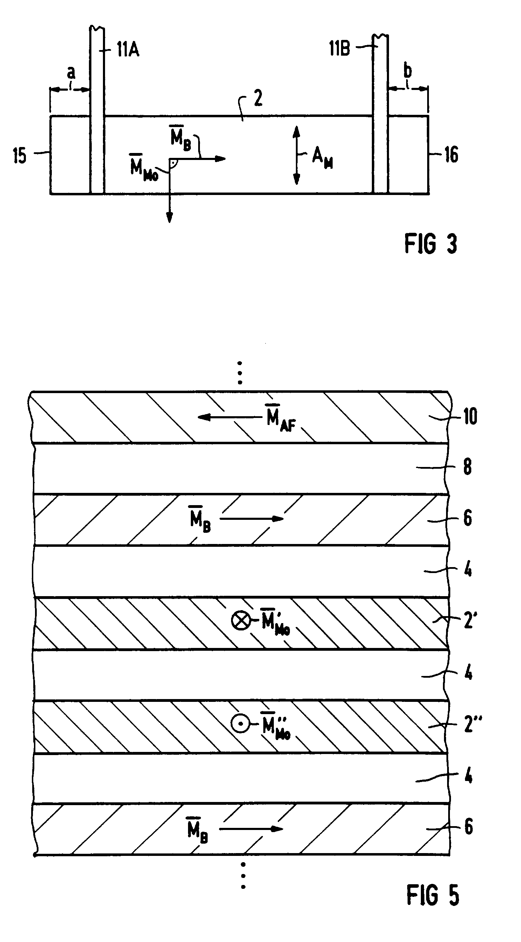

In einer vorteilhaften Ausführungsform gemäß FIG. 3 sind die Schichten als längliche Streifen ausgebildet, deren Längsrichtung senkrecht zur Grundzustandsmagnetisierung $\overline{M}_{MO}$ der Meßschicht 2 und damit auch parallel zur Magnetisierung $\overline{M}_B$ der Biasschicht 6 verläuft. Durch diese Maßnahme werden die dem Meßfeld entgegengesetzt gerichteten entmagnetisierenden Felder deutlich abgeschwächt und somit die Empfindlichkeit des Sensors erhöht sowie eine Verschiebung der Meßkennlinie vermieden. An den Enden 15 und 16 der Meßschicht 2 treten jedoch immer noch entmagnetisierende Felder auf, die eine Messung im Bereich dieser Enden 15 und 16 verfälschen. Deshalb sind zwei zur Widerstandsmessung vorgesehene Meßkontakte 11A und 11B in Längsrichtung um einen Abstand a bzw. b nach innen versetzt. Vorzugsweise sind beide Abstände a und b gleich groß. Die Meßkontakte 11A und 11B sind vorzugsweise auf der Meßschicht 2 angeordnet, können aber auch auf einer Biasschicht oder einer Zwischenschicht angeordnet sein.

In einer nicht dargestellten Ausführungsform mit cpp-Meßkontakten können die Meßkontakte ebenfalls in einen inneren Meßbereich verlegt sein.

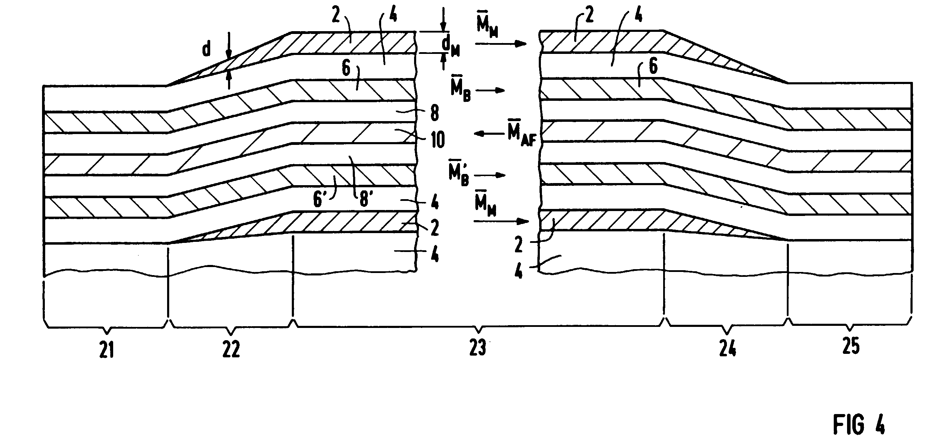

Um den Magnetfluß der Biasschichten 6 über den Meßschichten 2 weiter zu unterdrücken, sind in einer bevorzugten Ausführungsform gemäß FIG. 4 zwei Randbereiche 21 und 25 vorgesehen, in denen keine Meßschicht 2 vorhanden ist, und ein mittlerer Meßbereich 23 mit Meßschichten 2. Diese Verkürzung der Meßschichten 2 wird wenigstens in Richtung parallel zur Magnetisierung $\overline{M}_B$ der Biasschicht 6 und vorzugsweise in allen Richtungen vorgenommen, so daß die Biasschichten 6 ringsum über die Meßschichten hinausragen. Die Zwischenschichten 4 sind vorzugsweise so lang wie die Biasschichten 6. Der "künstliche Antiferromagnet" besteht in der dargestellten Ausführungsform aus zwei Biasschichten 6 und 6' und einer mittleren Magnetschicht 10 mit einer Magnetisierung $\overline{M}_{AF}$, die über jeweils eine Kopplungsschicht 8 oder 8' mit den Biasschichten 6 bzw. 6' antiferromagnetisch gekoppelt ist. Auf jeder Biasschicht 6 und 6' ist im Meßbereich 23 eine Zwischenschicht 4 und darauf eine Meßschicht 2 angeordnet. Es können natürlich auch wieder mehrere Subsysteme gemäß den in FIG. 1 oder 2 dargestellten Ausführungsformen vorgesehen sein. Die Magnetisierungen $\overline{M}_M$ der Meßschichten 2 sind, vorzugsweise durch ein nicht dargestelltes äußeres Sättigungsmagnetfeld, parallel zu den Magnetisierungen $\overline{M}_B$ gerichtet.

Zwischen den Randbereichen 21 und 25 und dem Meßbereich 23 ist jeweils ein Übergangsbereich 22 bzw. 24 vorgesehen, in dem die Dicke der Meßschichten 2 von außen nach innen kontinuierlich zunimmt. Während die Biasschichten 6 und die Zwischenschichten 4 in den Übergangsbereichen 22 und 24 wenigstens annähernd genauso dick sind wie in den Randbereichen 21 und 25 sowie im Meßbereich 23, nehmen die Dicken d der Meßschichten 2 in den Übergangsbereichen 22 und 24 unter einem bestimmten Öffnungswinkel von d=0 in den Randbereichen 21 und 25 bis zu einem konstanten Wert $d=d_M$ im Meßbereich 23 linear zu.

In einer nicht dargestellten Ausführungsform können zwischen den Randbereichen 21 und 25 und dem Meßbereich 23 jeweils eine Stufe sein, deren Höhen der Gesamtdicke der in den Randbereichen 21 und 25 fehlenden Meßschichten 2 entspricht.

In einer Ausführungsform gemäß FIG. 5 ist wenigstens eine Meßschicht 6 durch zwei Meßschichten 2' und 2" ersetzt. Die Grundzustandsmagnetisierungen $\overline{M}_{MO}'$ und $\overline{M}_{MO}"$ dieser beiden Meßschichten 2' und 2" sind nun, vorzugsweise durch Einprägen entsprechender Vorzugsachsen, antiparallel zueinander gerichtet und vorzugsweise gleich groß, d.h. $\overline{M}_{MO}' = -\overline{M}_{MO}"$. Damit bleibt der Magnetfluß der Meßschichten 2' und 2" im wesentlichen auf die Meßschichten 2' und 2" selbst beschränkt und greift nicht auf die benachbarten Biasschichten 6 über. Die Biasschichten 6 sind jeweils mit gleichgerichteten Magnetisierungen $\overline{M}_B$ versehen, die zuzumindest annähernd senkrecht zu den Grundzustandsmagnetisierungen $\overline{M}_{MO}'$ und $\overline{M}_{MO}"$ der Meßschichten 2' bzw. 2" gerichtet sind.

Wegen Schwankungen in den Richtungen der Vorzugsachsen und einem daraus resultierenden nicht eindeutigen Drehsinn für die Magnetisierungen $\overline{M}_M'$ und

$\overline{M}_M$" aus den Grundzustandsmagnetisierungen $\overline{M}_{MO}$' bzw. $\overline{M}_{MO}$" bilden sich im allgemeinen nach Sättigung in den Meßschichten 2' und 2" bei kleineren Feldwerten Domänen. In einer besonderen, nicht dargestellten Ausführungsform sind die Grundzustandsmagnetisierungen $\overline{M}_{MO}$' und $\overline{M}_{MO}$" der beiden Meßschichten 2' bzw. 2" zur Vermeidung dieser Domänenbildung jeweils um einen kleinen Winkel gegen die Normalenrichtung zur Magnetisierung $\overline{M}_B$ der Biasschichten 6 in unterschiedlichem Drehsinn eingestellt, so daß sie einen Winkel von etwas weniger als 180° miteinander einschließen. Dies kann durch Einprägen entsprechend zueinander geneigter Vorzugsachsen in die entsprechenden Meßschichten 2' und 2" erreicht werden. Dadurch ist für jede der beiden Magnetisierungen $\overline{M}_M$' und $\overline{M}_M$" bei Anliegen eines Magnetfeldes $\overline{H}$ ein eindeutiger Drehsinn aus der Sättigung vorgegeben.

Als magnetische Materialien für die Meßschichten können beispielsweise Co, Fe, Ni, SmCo oder auch Tb-FeCo und für die Biasschichten $Ni_{80}Fe_{20}$ oder auch $Ni_{66}CoFe$ vorgesehen sein. Die Zwischenschichten bestehen vorzugsweise aus Cu, Au, Ag oder Cr.

## Patentansprüche

1. Magnetowiderstands-Sensor mit

    a) einem Schichtsystem, das

    a1) wenigstens eine Meßschicht (2), die in der Schichtebene eine Magnetisierung ($\overline{M}_M$) aufweist, die wenigstens in einer Richtung reversibel von einem anliegenden Magnetfeld ($\overline{H}$) abhängt und bei fehlendem Magnetfeld ($\overline{H}$) einer vorgegebenen Grundzustandsmagnetisierung ($\overline{M}_{MO}$) entspricht, und
    a2) auf wenigstens einer Seite der Meßschicht (2) eine Biasschicht (6) mit einer im Meßbereich des Magnetfeldes ($\overline{H}$) wenigstens annähernd konstanten Magnetisierung ($M_B$) in der Schichtebene enthält, wobei
    a3) die Biasschicht (6) von der Meßschicht (2) durch eine Zwischenschicht (4) wenigstens annähernd magnetisch austauschentkoppelt ist,

    und mit

    b) Meßkontakten (11A und 11B) an dem Schichtsystem zum Erfassen eines Widerstandssignals, das ein Maß für das anliegende Magnetfeld ($\overline{H}$) ist,

    **dadurch gekennzeichnet**, daß

    c) an wenigstens eine Biasschicht (6) über eine Kopplungsschicht (8) eine Magnetschicht (10) antiferromagnetisch angekoppelt ist.

2. Magnetowiderstands-Sensor nach Anspruch 1, **dadurch gekennzeichnet**, daß an die Magnetschicht (10) an ihrer von der einen Biasschicht (6) abgewandten Seite eine weitere Biasschicht (6') über eine weitere Kopplungsschicht (8') antiferromagnetisch angekoppelt ist.

3. Magnetowiderstands-Sensor nach Anspruch 1 oder 2, **dadurch gekennzeichnet**, daß für jede Biasschicht (6, 6') ein Material mit einer von der Magnetschicht (10) verschiedenen Curietemperatur vorgesehen ist.

4. Magnetowiderstands-Sensor nach einem der Ansprüche 1 bis 3, **dadurch gekennzeichnet**, daß für jede Biasschicht (6, 6') ein Material mit einer von der Magnetschicht (10) verschiedenen Koerzitivfeldstärke vorgesehen ist.

5. Magnetowiderstands-Sensor nach einem der vorhergehenden Ansprüche, **dadurch gekennzeichnet**, daß jede Biasschicht (6, 6') entlang einer Vorzugsachse magnetisiert ist.

6. Magnetowiderstands-Sensor nach einem der vorhergehenden Ansprüche, **dadurch gekennzeichnet**, daß die Grundzustandsmagnetisierung ($\overline{M}_{MO}$) der Meßschicht (2) und die Magnetisierung ($\overline{M}_B$) der Biasschicht (6) wenigstens annähernd senkrecht zueinander gerichtet sind.

7. Magnetowiderstands-Sensor nach einem der Ansprüche 1 bis 5, **dadurch gekennzeichnet**, daß die Grundzustandsmagnetisierung ($\overline{M}_{MO}$) der Meßschicht (2) und die Magnetisierung ($\overline{M}_B$) der Biasschicht (6) parallel zueinander gerichtet sind.

8. Magnetowiderstands-Sensor nach einem der vorhergehenden Ansprüche, **dadurch gekennzeichnet** daß die Materialien für die Schichten derart gewählt sind, daß bei einer parallelen Ausrichtung der Magnetisierungen ($\overline{M}_M$ und $\overline{M}_B$) der Meßschicht (2) und der Biasschicht (6) der in der Meßschicht (2) am wenigsten gestreute Elektronentyp in mit dem einen Spinzustand auch in allen anderen magnetischen Schichten und an deren Grenzflächen weniger gestreut wird als der Elektronentyp mit dem anderen Spinzustand.

9. Magnetowiderstands-Sensor nach einem der vorhergehenden Ansprüche, **dadurch gekennzeichnet**, daß die Magnetisierung ($\overline{M}_B$) der Biasschicht (6) betragsmäßig kleiner gewählt ist als die Grundzustandsmagnetisierung ($\overline{M}_{MO}$) der Meßschicht (2).

**10.** Magnetowiderstands-Sensor nach einem der vorhergehenden Ansprüche, **dadurch gekennzeichnet**, daß die Meßschicht (2) und die Biasschicht (6) in einer Längsrichtung senkrecht zur Grundzustandsmagnetisierung ($\overline{M}_{MO}$) der Meßschicht (2) bevorzugt ausgedehnt sind.

**11.** Magnetowiderstands-Sensor nach einem der vorhergehenden Ansprüche, **dadurch gekennzeichnet**, daß die Meßschicht (2) wenigstens in einer Richtung parallel zur Magnetisierung ($\overline{M}_B$) der Biasschicht (6) kürzer ausgebildet ist als die Biasschicht (6).

**12.** Magnetowiderstands-Sensor nach Anspruch 11, **dadurch gekennzeichnet**, daß die Dicke der Meßschicht (2) in Übergangsbereichen (22 und 24) zwischen Randbereichen (21 bzw. 25) des Schichtsystems ohne die Meßschicht (2) und einem inneren Meßbereich (23) mit der Meßschicht (2) kontinuierlich zunimmt.

**13.** Magnetowiderstands-Sensor nach einem der vorhergehenden Ansprüche, **dadurch gekennzeichnet**, daß die Meßkontakte (11A und 11B) vom Rand des Schichtsystems beabstandet angeordnet sind.

**14.** Magnetowiderstands-Sensor nach einem der vorhergehenden Ansprüche, **dadurch gekennzeichzet**, daß die Meßkontakte auf der obersten und/oder der untersten Schicht des Schichtsystems angeordnet sind.

**15.** Magnetowiderstands-Sensor nach einem der vorhergehenden Ansprüche, **dadurch gekennzeichnet**, daß wenigstens eine Meßschicht (2) durch zwei Meßschichten (2' und 2") ersetzt ist, die durch eine Zwischenschicht (4) austauschentkoppelt sind.

**16.** Magnetowiderstands-Sensor nach Anspruch 15, **dadurch gekennzeichnet**, daß die Grundzustandsmagnetisierungen ($M_{MO}'$ und $M_{MO}''$) der beiden Meßschichten (2' und 2") wenigstens annähernd antiparallel zueinander gerichtet sind, wenn kein Magnetfeld ($\overline{H}$) anliegt.

**17.** Magnetowiderstands-Sensor nach Anspruch 16, **dadurch gekennzeichnet**, daß die Grundzustandsmagnetisierungen ($M_M'$ und $M_M''$) der beiden Meßschichten (2' und 2") um jeweils wenigstens annähernd den gleichen Winkel gegen die Normalenrichtung zur Magnetisierung ($\overline{M}_B$) der Biasschicht (6) geneigt sind und einen Winkel von weniger als 180° miteinander einschließen.

**18.** Magnetowiderstands-Sensor nach einem der vorhergehenden Ansprüche, **dadurch gekennzeichnet**, daß jede Meßschicht (2' und 2") in Richtung einer Vorzugsachse magnetisiert ist, wenn kein Magnetfeld $\overline{H}$ anliegt.

**19.** Magnetowiderstands-Sensor nach einem der vorhergehenden Ansprüche, **dadurch gekennzeichnet**, daß jede Magnetschicht (10) entlang einer Vorzugsachse magnetisiert ist.

**20.** Verfahren zur Herstellung eines Magnetowiderstands-Sensors nach einem der vorhergehenden Ansprüche mit folgenden Merkmalen:

a) Für die Biasschicht (6) und die Magnetschicht (10) werden magnetische Materialien mit unterschiedlicher Curie-Temperatur $T_{c1}$ und $T_{c2}$, mit wenigstens annähernd gleicher Magnetisierung bei einer Einsatztemperatur und mit unterschiedlichen Magnetisierbarkeiten bei einer von der Einsatztemperatur verschiedenen Einprägetemperatur ($T_E$) gewählt;
b) die durch die Kopplungsschicht (8) miteinander verbundene Biasschicht (6) und Magnetschicht (10) werden auf die Einprägetemperatur ($T_E$) gebracht und in einem temperaturabhängigen Biasmagnetfeld ($H_B$) gesättigt, das wenigstens bei der Einprägetemperatur ($T_E$) einen von Null verschiedenen Wert zum Sättigen hat;
c) anschließend werden die Schichten auf die Einsatztemperatur gebracht.

**21.** Verfahren zur Herstellung eines Magnetowiderstands-Sensors nach einem der Ansprüche 1 bis 19 mit folgenden Merkmalen:

a) Für die Biasschicht (6) und die Magnetschicht (10) werden magnetische Materialien mit unterschiedlichen Koerzitivfeldstärken ausgewählt;
b) die durch die Kopplungsschicht (8) miteinander verbundene Biasschicht (6) und Magnetschicht (10) werden in einem Sättigungsmagnetfeld gesättigt.

**Claims**

**1.** Magnetoresistive sensor comprising

a) a layer system comprising

a1) at least one measuring layer (2) which, in the plane of the layer, has a magnetization ($\overline{M}_M$) which at least in one direction depends reversibly on a magnetic field ($\overline{H}$)

applied and, if the magnetic field ($\bar{H}$) is absent, corresponds to a predefined ground state magnetization ($\bar{M}_{MO}$); and

a2) on at least one side of the measuring layer (2) a bias layer (6) having a magnetization ($M_B$) in the plane of the layer, which magnetization is at least approximately constant in the measuring range of the magnetic field ($\bar{H}$),

a3) the bias layer (6) being at least approximately magnetically exchange-decoupled from the measuring layer (2) by an interlayer (4),

and comprising

    b) measuring contacts (11A and 11B) on the layer system to detect a resistance signal which is a measure for the magnetic field ($\bar{H}$) applied,

characterized in that

    c) to at least one bias layer (6) a magnetic layer (10) is coupled antiferromagnetically via a coupling layer (8).

2. Magnetoresistive sensor according to Claim 1, characterized in that there is coupled antiferromagnetically, to the magnetic layer (10) on its side facing away from the one bias layer (6), a further bias layer (6') via a further coupling layer (8').

3. Magnetoresistive sensor according to Claim 1 or 2, characterized in that there is provided, for each bias layer (6, 6'), a material having a Curie temperature which differs from that of the magnetic layer (10).

4. Magnetoresistive sensor according to any one of Claims 1 to 3, characterized in that there is provided, for each bias layer (6, 6'), a material having a coercive field strength which differs from that of the magnetic layer (10).

5. Magnetoresistive sensor according to any one of the preceding claims, characterized in that each bias layer (6, 6') is magnetized along a preferred axis.

6. Magnetoresistive sensor according to any one of the preceding claims, characterized in that the ground state magnetization ($\bar{M}_{MO}$) of the measuring layer (2) and the magnetization ($\bar{M}_B$) of the bias layer (6) are aligned at least approximately perpendicular to each other.

7. Magnetoresistive sensor according to any one of Claims 1 to 5, characterized in that the ground state magnetization ($\bar{M}_{MO}$) of the measuring layer (2) and the magnetization ($\bar{M}_B$) of the bias layer (6) are aligned parallel to each other.

8. Magnetoresistive sensor according to any one of the preceding claims, characterized in that the materials for the layers are chosen in such a way that in the case of a parallel alignment of the magnetizations ($\bar{M}_M$ and $\bar{M}_B$) of the measuring layer (2) and the bias layer (6), the type of electrons which is scattered least in the measuring layer (2) and has the one spin state is similarly scattered less in all the other magnetic layers and at their interfaces than is the electron type having the other spin state.

9. Magnetoresistive sensor according to any one of the preceding claims, characterized in that the magnitude of the magnetization ($\bar{M}_B$) of the bias layer (6) is chosen to be smaller than that of the ground state magnetization ($\bar{M}_{MO}$) of the measuring layer (2).

10. Magnetoresistive sensor according to any one of the preceding claims, characterized in that the measuring layer (2) and the bias layer (6) are preferentially extended in a longitudinal direction perpendicular to the ground state magnetization ($\bar{M}_{MO}$) of the measuring layer (2).

11. Magnetoresistive sensor according to any one of the preceding claims, characterized in that the measuring layer (2) is shorter, in at least one direction parallel to the magnetization ($\bar{M}_B$) of the bias layer (6), than the bias layer (6).

12. Magnetoresistive sensor according to Claim 11, characterized in that the thickness of the measuring layer (2) in transition zones (22 and 24) between boundary zones (21 and 25, respectively) of the layer system without the measuring layer (2) and an inner measuring zone (23) with the measuring layer (2) increases continuously.

13. Magnetoresistive sensor according to any one of the preceding claims, characterized in that the measuring contacts (11A and 11B) are arranged so as to be at a distance from the boundary of the layer system.

14. Magnetoresistive sensor according to any one of the preceding claims, characterized in that the measuring contacts are arranged on the uppermost and/or the lowermost layer of the layer system.

15. Magnetoresistive sensor according to any one of the preceding claims, characterized in that at least one measuring layer (2) has been replaced by two measuring layers (2' and 2") which are exchange-decoupled by an interlayer (4).

**16.** Magnetoresistive sensor according to Claim 15, characterized in that the ground state magnetizations ($M_{MO}$' and $M_{MO}$") of the two measuring layers (2' and 2") are aligned at least approximately antiparallel with respect to one another, when no magnetic field ($\overline{H}$) is applied.

**17.** Magnetoresistive sensor according to Claim 16, characterized in that the ground state magnetizations ($\overline{M}_M$' and $\overline{M}_M$") of the two measuring layers (2' and 2") are each inclined by at least approximately the same angle with respect to the direction of the normal to the magnetization ($\overline{M}_B$) of the bias layer (6) and between one another enclose an angle of less than 180°.

**18.** Magnetoresistive sensor according to any one of the preceding claims, characterized in that each measuring layer (2' and 2") is magnetized in the direction of a preferred axis when no magnetic field $\overline{H}$ is applied.

**19.** Magnetoresistive sensor according to any one of the preceding claims, characterized in that each magnetic layer (10) is magnetized along a preferred axis.

**20.** Method for fabricating a magnetoresistive sensor according to any one of the preceding claims, which comprises the following features:

a) for the bias layer (6) and the magnetic layer (10), magnetic materials having different Curie temperatures $T_{c1}$ and $T_{c2}$ and at least approximately equal magnetizations at an operating temperature and different magnetizabilities at an impressing temperature ($T_E$) which differs from the operating temperature are selected;
b) the bias layer (6) and magnetic layer (10) bonded to one another by the coupling layer (8) are brought to the impressing temperature ($T_E$), and are saturated in a temperature-dependent biasing magnetic field ($H_B$) whose value for saturation differs from zero, at least at the impressing temperature ($T_E$);
c) then the layers are brought to the operating temperature.

**21.** Method for fabricating a magnetoresistive sensor according to any one of Claims 1 to 19, which comprises the following features:

a) the magnetic materials selected for the bias layer (6) and the magnetic layer (10) have different coercive field strengths;
b) the bias layer (6) and magnetic layer (10) bonded to one another by the coupling layer (8) are saturated in a saturation magnetic field.

**Revendications**

1. Capteur à mégnorésistance comportant

a) un système de couches, qui

a1) comporte au moins une couche de mesure (2), qui a, dans son plan, une aimantation ($\overline{M}_M$), qui, au moins dans une direction, dépend d'une manière réversible d'un champ magnétique appliqué ($\overline{H}$) et correspond, en absence d'un champ magnétique ($\overline{H}$), à une aimantation prescrite d'état de base ($\overline{M}_{MO}$) et
a2) comprend, sur au moins une face de la couche de mesure (2), une couche de polarisation (6) ayant une aimantation ($M_B$) au moins approximativement constante dans la zone de mesure du champ magnétique ($\overline{H}$) et située dans le plan de la couche,
a3) la couche de polarisation (6) étant au moins approximativement découplée magnétiquement, selon un découplage d'échange, de la couche de mesure (2) par une couche intercalaire (4), et

comportant

b) des contacts de mesure (11A et 11B) disposés sur le système de couches pour détecter un signal de résistance, qui est une mesure du champ magnétique ($\overline{H}$) appliqué,

caractérisé par le fait que

c) une couche magnétique (10) est couplée d'une manière antiferromagnétique à au moins une couche de polarisation (6) par l'intermédiaire d'une couche de couplage (8).

2. Capteur à magnétorésistance suivant la revendication 1, caractérisé par le fait qu'une autre couche de polarisation (6') est couplée d'une manière antiferromagnétique à la couche magnétique (10), à la face, éloignée de la couche de polarisation (6), de cette couche magnétique par l'intermédiaire d'une autre couche de couplage (8').

3. Capteur à magnétorésistance suivant la revendication 1 ou 2, caractérisé par le fait que pour chaque couche de polarisation (6,6'), il est prévu un matériau ayant une température de Curie qui diffère de celle de la couche magnétique (10).

4. Capteur à magnétorésistance suivant l'une des revendications 1 à 3, caractérisé par le fait que pour chaque couche de polarisation (6,6') il est prévu un matériau possédant une intensité de champ coercitif différente de celle de la couche magnétique (10).

5. Capteur à magnétorésistance suivant l'une des revendications précédentes, caractérisé par le fait que chaque couche de polarisation (6,6') est aimantée le long d'un axe préférentiel.

6. Capteur à magnétorésistance suivant l'une des revendications précédentes, caractérisé par le fait que l'aimantation d'état de base ($\overline{M}_{MO}$) de la couche de mesure (2) et l'aimantation ($\overline{M}_B$) de la couche de polarisation (6) sont dirigées au moins approximativement perpendiculairement l'une à l'autre.

7. Capteur à magnétorésistance suivant l'une des revendications 1 à 5, caractérisé par le fait que l'aimantation d'état de base ($\overline{M}_{MO}$) de la couche de mesure (2) et l'aimantation ($\overline{M}_B$) de la couche de polarisation (6) sont dirigées parallèlement l'une à l'autre.

8. Capteur à magnétorésistance suivant l'une des revendications précédentes, caractérisé par le fait que les matériaux pour les couches sont choisis de telle sorte que, dans le cas d'une orientation parallèle des aimantations ($\overline{M}_M$ et $\overline{M}_B$) de la couche de mesure (2) et de la couche de polarisation (6), le type d'électrons, qui est le moins dispersé dans la couche de mesure (2) et a un des états de spin, est également moins dispersé, dans toutes les autres couches magnétiques et au niveau de leurs interfaces, que le type d'électrons ayant l'autre état de spin.

9. Capteur à magnétorésistance suivant l'une des revendications précédentes, caractérisé par le fait que la valeur de l'aimantation ($\overline{M}_B$) de la couche de polarisation (6) est choisie de module inférieur à l'aimantation d'état de base ($\overline{M}_{MO}$) de la couche de mesure (2).

10. Capteur à magnétorésistance suivant l'une des revendications précédentes, caractérisé par le fait que la couche de mesure (2) et la couche de polarisation (6) sont élargies de préférence dans une direction longitudinale perpendiculairement à l'aimantation d'état de base ($\overline{M}_{MO}$) de la couche de mesure (2).

11. Capteur à magnétorésistance suivant l'une des revendications précédentes, caractérisé par le fait que la couche de mesure (2) est plus courte que la couche de polarisation (6), au moins dans une direction parallèle à l'aimantation ($\overline{M}_B$) de la couche de polarisation (6).

12. Capteur à magnétorésistance suivant la revendication 11, caractérisé par le fait que l'épaisseur de la couche de mesure (2) augmente continûment dans des zones de jonction (22 et 24) entre des zones marginales (21 ou 25) du système de couches sans la couche de mesure (2) et une zone intérieure de mesure (23) comportant la couche de mesure (2).

13. Capteur à magnétorésistance suivant l'une des revendications précédentes, caractérisé par le fait que les contacts de mesure (11A et 11B) sont disposés à distance du bord du système de couches.

14. Capteur à magnétorésistance suivant l'une des revendications précédentes, caractérisé par le fait que les contacts de mesure sont disposés sur la couche la plus haute et/ou sur la couche la plus basse du système de couches.

15. Capteur à magnétorésistance suivant l'une des revendications précédentes, caractérisé par le fait qu'au moins une couche de mesure (2) est remplacée par deux couches de mesure (2' et 2"), qui ont un découplage d'échange au moyen d'une couche intercalaire (4) .

16. Capteur à magnétorésistance suivant la revendication 15, caractérisé par le fait que les aimantations d'état de base ($M_{MO}'$ et $M_{MO}"$) des deux couches de mesure (2' et 2") sont dirigées au moins approximativement d'une manière antiparallèle, lorsqu'aucun champ magnétique ($\overline{H}$) n'est appliqué.

17. Capteur à magnétorésistance suivant la revendication 7, caractérisé par le fait que les aimantations d'état de base ($\overline{M}_M'$ et $\overline{M}_M"$) des deux couches de mesure (2' et 2") sont inclinées chacune au moins approximativement du même angle par rapport à la direction normale à l'aimantation ($\overline{M}_B$) de la couche de polarisation (6) et font entre elles un angle inférieur à 180°.

18. Capteur à magnétorésistance suivant l'une des revendications précédentes, caractérisé par le fait que chaque couche de mesure (2' et 2") est aimantée dans la direction d'un axe préférentiel, lorsqu'aucun champ magnétique ($\overline{H}$) n'est présent.

19. Capteur à magnétorésistance suivant l'une des revendications précédentes, caractérisé par le fait que chaque couche magnétique (10) est aimantée le long d'un axe préférentiel.

20. Procédé de fabrication d'un capteur à magnétorésistance suivant l'une des revendications précédentes, présentant les caractéristiques suivantes :

a) pour la couche de polarisation (6) et la couche magnétique (10), on choisit des matériaux magnétiques ayant des températures de Curie $T_{c1}$ et $T_{c2}$ différentes, et ayant au moins approximativement la même aimantation pour une température d'utilisation et des capacités d'aimantation différentes pour une température d'empreinte ($T_E$) différente de la température d'utilisation;

b) on place la couche de polarisation (6) et la couche magnétique (10), reliées entre elles par la couche de couplage (8), à la température d'empreinte ($T_E$) et on les sature dans un champ magnétique de polarisation ($H_B$) qui dépend de la température et qui a, pour la saturation, une valeur différente de zéro, au moins à la température d'empreinte ($T_E$) ;

c) ensuite, on amène les couches à la température d'utilisation.

21. Procédé de fabrication d'un capteur à magnétorésistance suivant l'une des revendications 1 à 19, présentant les caractéristiques suivantes :

a) pour la couche de polarisation (6) et la couche magnétique (10), on choisit des matériaux magnétiques, dont les champs coercitifs ont des intensités différentes;

b) on sature la couche de polarisation (6) et la couche magnétique (10), qui sont reliées entre elles par la couche de couplage (8), dans un champ magnétique de saturation.

⊗ $\overline{M}_{Mo}(A_M)$ — 2

4

$\overline{M}_B$ ⟶ — 6

8

⟵ $\overline{M}_{AF}$ — 10

## FIG 1

⟵ $\overline{H}$

⟵ $\overline{M}_M$ — 2

4

⟵ $\overline{M}_B$ — 6

8

$\overline{M}_{AF}$ ⟶ — 10

8'

⟵ $\overline{M}_B'$ — 6'

## FIG 2

14

**FIG 3**

**FIG 5**

FIG 4

EP 0 674 769 B1